(19) Europäisches Patentamt
European Patent Office
Office européen des brevets

(11) Publication number: 0 080 945 B1

(12) **EUROPEAN PATENT SPECIFICATION**

(45) Date of publication of patent specification: **23.05.90**

(51) Int. Cl.[5]: **H 01 L 33/00,** H 01 S 3/19, H 01 L 27/15, H 01 L 31/16

(21) Application number: **82402152.1**

(22) Date of filing: **26.11.82**

(54) **Optical semiconductor device.**

(30) Priority: **30.11.81 JP 192578/81**
**31.03.82 JP 53119/82**

(43) Date of publication of application:
**08.06.83 Bulletin 83/23**

(45) Publication of the grant of the patent:
**23.05.90 Bulletin 90/21**

(84) Designated Contracting States:
**DE FR GB**

(56) References cited:
**DE-A-2 031 444**
**US-A-3 740 661**
**US-A-4 080 617**

**Toshiba Review, no. 102, March-April, 1976, pages 29-34, Kanagawa, JP, A. Kasami et al.:"High-performance GaP green LED display"**
**Electronic Letters, vol. 16, no. 9, April 24, 1980, pages 342-343, Hitchen,GB, Iga K. et al.:"GaInAsP/InP laser with monolithically integrated monitoring detector"**

(73) Proprietor: **FUJITSU LIMITED**
**1015, Kamikodanaka Nakahara-ku**
**Kawasaki-shi Kanagawa 211 (JP)**

(72) Inventor: **Hori, Ken-ichi**
**2-12-2, Tamami Asao-ku**
**Kawasaki-shi Kanagawa 215 (JP)**
Inventor: **Yamakoshi, Shigenobu**
**117-1-601, Nakashinden**
**Ebina-shi Kanagawa 243 (JP)**

(74) Representative: **Descourtieux, Philippe et al**
**CABINET BEAU de LOMENIE 55 rue d'Amsterdam**
**F-75008 Paris (FR)**

**EP 0 080 945 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to an optical semiconductor device, particularly to an optical semiconductor device including combination of one or plurality of optical semiconductor devices, or combination of an optical semiconductor device and electrical circuit elements within one semiconductor substrate.

A semiconductor laser element which is one type of optical semiconductor device has usually the structure shown for example by Fig. 1.

In this Figure, 11 is an n-type InP substrate; 12 is an n-type InP buffer layer equivalently working as cladding layer; 13 is an active layer consisting of InGaAsP; 14 is a p-type InP cladding layer; 15 is an insulating layer consisting of silicon dioxide ($SiO_2$); 16 is a p side electrode; 17 is an n side electrode.

In such a semiconductor laser, the current injection region is defined by said insulating layer 15 as shown by a striped region. A positive voltage is applied to the p side electrode 16 while a negative voltage is applied to the n side electrode 17. The carrier is thereby injected into the active layer 13, thus causing the light to be emitted through recombination.

The light emitted has a photon energy larger than the band gap energy of the active layer 13 and is confined within the active layer 13 sandwiched by the cladding layers 12 and 14 having a refractive index lower than that of the active layer 13.

However, the light once penetrating into the cladding layers 12, 14 and scattering at the interface between the active layers 13 and cladding layers 12, 14 (hereinafter referred to as leakage light) propagates through the InP cladding layers 12 and 14. At this time, since the band gap of InP is wider than that of InGaAsP of the active layer 13, the leakage light propagates within the InP crystal without any attenuation and then returns to the active layer 13 again after it is reflected at the interface of crystals due to the Fresnel reflection effect or by the electrodes 16, 17 arranged on the elements. This returning light not only causes the oscillation of this semiconductor laser element to be unstable but also disturbs spacially the light emitting pattern or causes such pattern to be unstable.

Fig. 2 shows the light emitting for field pattern in the direction perpendicular to the junction of the crystal and the zig-zag portion indicates the disturbance of the emitting pattern generated when the returning light enters the active layer 13. Such disturbance of light emitting for field pattern causes the coherence to be bad and results, for example, in deterioration of the resolution in the case of picture processing.

In a device containing semiconductor light emitting elements, optical semiconductor devices such as photo transistor, FET or electrical circuit elements on one substrate, said leakage light or said returning light from said semiconductor light emitting element are captured as noise by the optical semiconductor and FET or electrical circuit elements formed adjacently on the same substrate and cause these elements to be unstable.

For example, when configurating an optical integrated circuit by forming a semiconductor laser element and a Schottky barrier type field effect transistor element which drives said semiconductor laser element on the same substrate, the leakage light from the active region of said semiconductor laser element reaches the channel region of said transistor element and thereby causes generation of unwanted carriers in said channel region.

Such generation of unwanted carrier results in malfunction of the pertinent transistor element.

This phenomenon becomes more distinctive when the distance between semiconductor laser element and transistor element becomes short, namely when integration density becomes high.

Namely, with conventional optical integrated semiconductor devices, the problem is raised of the difficulty to realize a high integration density because the characteristic of electronic devices is deteriorated by the effect of light emitted from an optical semiconductor device such as laser device and moreover such phenomenon becomes more distinctive when integration density is more and more improved.

DE—A—2031444 discloses an integrated array of light emitting diodes wherein the electrical insulation between the light emitting regions is improved by providing a light absorbing layer between the light emitting p-n junctions and the semiconductor substrate.

In order to avoid the disadvantages of conventional optical semiconductor devices, the object of the present invention is to provide an optical semiconductor device wherein the leakage light from the light emitting region of a semiconductor light emitting element is prevented to enter the semiconductor emitting element itself or the operating region of another semiconductor element formed on the same substrate together with said semiconductor light emitting element.

According to the present invention, in an optical semiconductor device comprising a semiconductor substrate having top and bottom surfaces, a light emitting element formed on the semiconductor substrate, at least another semiconductor element formed on the semiconductor substrate adjacent to said light emitting element, and an electrode formed on said bottom surface, a light absorbing layer is formed directly or indirectly on the semiconductor substrate between said other semiconductor element and said electrode, so as to prevent leakage light from said light emitting element, even when it is reflected by said electrode, to reach said other semiconductor element.

In the drawings:

Fig. 1 is a sectional view showing the structure of a conventional semiconductor laser element,

Fig. 2 is a field pattern distribution perpendicular to the junction plane of said conventional semiconductor laser element,

Fig. 3 is a sectional view showing the structure of a semiconductor laser element which is one of optical semiconductor devices according to the present invention,

Fig. 4 shows a field pattern distribution perpendicular to the junction plane of said semiconductor layer element according to the present invention,

Fig. 5 is a sectional view showing the structure of an optical semiconductor device where a plurality of semiconductor laser elements are arranged on the same substrate, forming an optical semiconductor device according to the present invention,

Fig. 6 is a sectional view showing the structure of an integrated circuit element where a semiconductor laser element and an optical sensing element are arranged on a same substrate, forming a photo semiconductor device according to the present invention,

Fig. 7 is a sectional view showing the structure of an optical integrated circuit element where a semiconductor laser element and electrical circuit elements are arranged on a same substrate, forming an optical semiconductor device according to the present invention, and

Fig. 8 is a sectional view showing a modification of the optical integrated circuit element shown in Fig. 7.

Fig. 3 shows a semiconductor laser element which is one of the optical semiconductor devices according to the present invention.

In such a semiconductor laser element, a buffer layer 32 consisting of n-type indium/phosphide (InP) is formed with a thickness of about 5 µm on a substrate 31 consisting of n-type indium/phosphide (InP) by means of liquid phase epitaxial growth technique and/or vapor phase epitaxial growth technique and/or molecular beam epitaxial growth technique.

On said buffer layer 32, a first light absorbing layer 33 associated to this invention is formed. Said first light absorbing layer 33 is composed of an n-type indium/gallium/arsenide/phosphide. (InGaAsP) layer.

On said light absorbing layer 33, a first cladding layer 34 consisting of n-type indium/phosphide (InP) is formed with a thickness of about 1.5 µm, and on said first cladding layer 34, an active layer 35 consisting of indium/gallium/arsenide/phosphide (InGaAsP) is formed with a thickness of about 0.15 µm.

In addition, a second cladding layer 36 consisting of p-type indium/phosphide (InP) is formed with a thickness of about 1.5 µm on said active layer 35 and a second light absorbing layer 37 consisting of p-type indium/gallium/arsenide phosphide (InGaAsP) is formed on said second cladding layer 36.

Then, on said second light absorbing layer 37, an insulating film 38 consisting of silicon dioxide ($SiO_2$) is deposited and, on said insulating film 38, an electrode 39 consisting of titanium/platinum/gold (Ti/Pt/Au) is deposited.

Additionally, an electrode 40 consisting of a gold/germanium (Au/Ge) layer and of a nickel (Ni) layer is deposited at the back side surface of said substrate 31.

When the light emitted has a wavelength of 1.3 µm, the active layer 35 had the following composition: $In_{0.69}Ga_{0.31}As_{0.66}P_{0.34}$; and when the wavelength at the absorbing edge is 1.4 µm, the light absorbing layers 33, 37 have the following composition:

$$In_{0.63}Ga_{0.37}As_{0.78}P_{0.22}.$$

When the wavelength of the light emitted in said active layer 35 is 1.3 µm in such a semiconductor laser element, if the wavelength at the absorbing edge of the light absorbing layers 33, 37 is set to 1.4 µm, the absorbing coefficient $\alpha$ of said light absorving layers 33, 37 becomes round $1 \times 10^4 cm^{-1}$.

When the incident light of intensity Io passes through the semiconductor crystal having the absorbing coefficient $\alpha$ and thickness d, the intensity of light having passed said semiconductor crystal is expressed as follows:

$$I = I_o.e^{-\alpha d}$$

Therefore, when $\alpha d \geqq 1$, the relation $I \leqq I_o.e^{-1}$ can be obtained and the optical intensity of the transmitting light can be reduced remarkably.

Therefore, setting of thickness to 1 µm in said light absorbing layers 33, 37 satisfies the relation $\alpha d \geqq 1$, and a reduction of leakage light intensity of more than 63% is obtained when the light passes said light absorbing layers 33, 37, and of more than 86% for round-trip.

In such a semiconductor element, a positive voltage is applied to the electrode 39 while a negative voltage to the electrode 40; a current is applied only to the region striped by the insulating film 38 of the active layer 35 and a laser oscillation (light emission) can be obtained through recombination in said active layer 35.

The light emitted is trapped within the active layer 35 by the effect of cladding layers 34 and 36 but a part of such light penetrates into said cladding layers 34 and 36 or goes out of the active layer 35 as leakage light by scattering at the interface of the active layer 35 and cladding layers 34, 36, propagating into the semiconductor layer forming said semiconductor laser element.

However, due to the provision of the light absorbing layers 33, 37 in this embodiment, said leakage light propagating toward the electrodes 39, 40 passes through said absorbing layers 33, 37. At this time, when said leakage light has an intensity $I_o$, the intensity I of light having passed said light absorbing layers 33, 37 becomes lower than $I_o.e^{-1}$ ($I \leqq I_o.e^{-1}$) assuming that $\alpha d \geqq 1$. The light having passed these light absorbing layers 33, 37 changes to a returning light due to the Fresnel reflection at the interface of crystals and reflection by electrodes 39, 40 and then passes again through the light absorbing layers 33, 37. As a result, the light having passed said light

absorbing layers 33, 37 has an intensity $I' \geqq R.I_o.e^{-2}$, where R is a reflection coefficient and $R < 1$.

As explained above, the intensity of light returning to the active layer 35 can be reduced at about one order of magnitude or more by providing the light absorbing layers 33, 37. As a result, the oscillation considered from the point of view of output power can be stabilized, and the light emitting pattern can be prevented from spatial disturbance and can also be stabilized.

Fig. 4 shows the light emitting for field pattern perpendicular to the junction of laser diode in the preferred embodiment. Since the amount of leakage light returning to the active layer 35 can be reduced by providing the light absorbing layers 33, 37, the light emitted is not disturbed.

Fig. 5 shows, as another optical semiconductor device according to the present invention, an optical semiconductor device including a plurality of semiconductor laser elements formed in the form of an array on a same semiconductor substrate.

In such a semiconductor device, the buffer layer 52, consisting of n-type InP, is formed with a thickness of about 5 µm on the substrate 51 consisting of n-type InP and the first light absorbing layer 53 in accordance with this invention is formed on said buffer layer 52. Said light absorbing layer 53 is composed of n-type InGaAsP layer with a thickness of about 2.5 µm.

On said light absorbing layer 53, a first cladding layer 54 consisting of n-type InP is formed with a thickness of about 1.5 µm, and in said first cladding layer 54, active layers 55a, 55b, ... consisting of InGaAsP are selectively formed with a thickness of about 0.15 µm.

In addition, a second cladding layer 56 consisting of p-type InP is formed with a thickness of about 1.5 µm on said active layers 55a, 55b..., while a second light absorbing layer 57 consisting of n-type InGaAsP is formed on said second cladding layer 56.

Then, a contact layer 58 consisting of an n-type InGaAsP layer is formed with a thickness of about 1 µm on said second light absorbing layer 57. Then p-type current paths 59a, 59b... are formed in the region corresponding to said active layers 55a, 55b, ..., passing through the n-type InGaAsP layer 58 and the second light absorbing layer 57 and reaching the second cladding layer 56. Said p-type current paths 59a, 59b, ... are formed by selective introduction of zinc (Zn) or cadmium (Cd).

The insulating layer 60 consisting of the silicon dioxide is selectively deposited on the surface of the n-type InGaAsP layer 58 between said p-type current paths 59a, 59b, ... and high resistance regions 61a, 61b, ... are formed below said insulating layer 60, passing through the n-type InGaAsP layer 58 and the second light absorbing layer 57 and reaching the second cladding layer 56, and each of said active layers 55a, 55b, ... is electrically separated. Said high resistance regions 61a, 61b, ... are formed by selective implantation of protons.

Additionally, an electrode 62 is formed on said n-type InGaAsP layer 58, and an electrode 63 is formed at the back side surface of the n-type InP substrate 51.

In this structure, the first light absorbing layer 53 is formed with protruding portions 53a, 53b, ... coming in contact with the second cladding layer 56 in the area corresponding to said high resistance regions 61a, 61b, ... and formed between the active layers 55a, 55b, ...

In such an optical semiconductor device, the active layer 55 has the following composition:

$$In_{0.69}Ga_{0.31}As_{0.66}P_{0.34}$$

when the wavelength of light emitted is 1.3 µm, while the light absorbing layers 53, 57 has the following composition:

$$In_{0.63}Ga_{0.37}As_{0.78}P_{0.22}$$

when the wavelength at the absorbing edge is 1.4 µm.

In the case of an optical semiconductor device having such a structure, the leakage light from the light emitting region of each semiconductor laser element and the light coming from the electrodes 62 and 63 by reflection are absorbed by the light absorbing layers 53, 57 and the amount of light which penetrates into the own or other light emitting region is reduced. In addition, the leakage light which directly propagates to the other light emitting region from the active region of said semiconductor laser element is absorbed by the protruded portions 53a, 53b, ... of said light absorbing layer 53 and a less amount of light penetrates into the other light emitting region.

Fig. 6 is an optical semiconductor device according to the present invention, including a semiconductor laser element LD and a photo transistor PT on a same semiconductor substrate.

In such an optical semiconductor device, a light absorbing layer 72 consisting of an n-type InGaAsP layer is formed with a thickness of about 1 µm on a substrate 71 consisting of n-type InP. An n-type InP layer 73 with a thickness of about 5 µm and a p-type InP layer 74 with a thickness of about 1 µm are formed in the semiconductor laser element LD forming region $A_L$ on said light absorbing layer 72.

In a V-shaped groove 75 provided with such a depth as to reach said n-type InP layer 73 from said p-type InP layer 74, a first cladding layer 76 consisting of n-type InP and an active layer 77 consisting of InGaAsP are formed. At this time, n-type InP layer 76′ and InGaAsP layer 77′ are also formed on said p-type InP layer 74. A second cladding layer 78 consisting of p-type InP is formed on the active layer 77 in said groove 75, and extends to the region on said InGaAsP layer 77′.

Additionally, on said second cladding layer 78, an electrode 80 is deposited via a p-type InGaAsP layer 79 with a thickness of about 1 μm.

On the other hand, in the photo transistor PT forming region $A_T$ which is provided separately from said semiconductor laser element region $A_L$ by a groove 81 provided with such a depth as to pass through said p-type InP layer 74 and to reach the n-type InP layer 73, the emitter or collector of a photo transistor is formed by an n-type InP layer 73', the base of the photo transistor is formed by a p-type InGaAsP layer 82 and the collector or emitter of the photo transistor is formed by an n-typ InP layer 83 selectively formed on said p-type InGaAsP layer 82.

On said n-type Inp layer 83, the electrode 84 is formed, while at the back side surface of substrate 71 consisting of the n-type InP, the electrode 85 is formed.

In such a structure, a current to the active layer 77 of a semiconductor laser element LD flows along the path sandwiched by the reverse bias junctions between the p-type InP layer 74 and the n-type InP 76' formed outside the V-shaped groove 75 and thereby flows effectively into said active layer 77.

In such an optical semiconductor device, a light signal L received at the light receiving region AP of the photo transistor PT is converted to an electrical signal and is then amplified by said photo transistor PT. This amplified signal drives a semiconductor laser element LD via a driving transistor element and thereby a light signal higher than said light signal L can be emitted from the semiconductor laser element LD.

The driving transistor element can be formed monolithically on the suitable semiconductor substrate.

A part of the output of such a semiconductor laser element LD is leaked and is reflected by the elctrode 85. When it is applied to the photo transisotr PT, it appears as noise. But since the light absorbing layer 72 is provided in this embodiment, such leakage light is sufficiently attenuated, thus reducing the noise level at the photo transistor PT.

It is desirable, in such a structure, that said groove 81 be formed in such a depth as to reach the light absorbing layer 72. With such a structure, the leakage light into the semiconductor substrate, from that emitted by the semiconductor laser element LD, is effectively absorbed by the light absorbing layer 72.

In the above structure, in addition, the light absorbing layer 72 is not always required to be formed just below both the semiconductor laser element LD and the photo transistor PT, and may be formed just below any one of the semiconductor laser element LD and the phototransistor PT provided that the thickness of said light absorbing layer 72 is sufficient for showing the effect of light absorbing.

Moreover, the present invention, of course, can be applied effectively in the case where a photo diode or avalanche photo diode is used in place of the photo transistor as light receiving element.

In such an embodiment, said active layer 77 of the semiconductor laser element LD has the following composition:

$$In_{0.69}Ga_{0.31}As_{0.66}P_{0.34}$$

when the wavelength of the light emitted is 1.3 μm, while said light absorbing layer 72 has the following composition:

$$In_{0.63}Ga_{0.37}As_{0.78}P_{0.22}$$

when the wavelength at the absorbing edge is 1.4 μm. In addition, the composition of the InGaAsP layer 82 forming the base of a photo transistor PT is selected in order that the receiving wavelength becomes 1.3 to 1.67 μm.

The structure shown in Fig. 6 provides the same effect as that of said embodiment when the light absorbing layer is formed of a plurality of layers and the sum of the products of the absorption coefficient with the thickness at each layer is set to be equal to 1 or larger than 1.

Fig. 7 shows a monolithically integrated device including a semiconductor laser element LD and electrical circuit elements ED for controlling said semiconductor laser elements LD, on the same semiconductor substrate, this device constituting one of the optical semiconductor devices according to the present invention.

In such an optical semiconductor device, a buffer layer which also forms a cladding layer 102, consisting of an n-type GaAlAs layer is formed with a thickness of about 1.5 μm on an $n^+$-type GaAs substrate 101 having a thickness of 100 μm, and an active layer 103 consisting of a $Ga_{1-x}Al_xAs(0 \leqq x \leqq 1)$ layer is formed with a thickness of about 0.1 μm on said buffer layer 102. Then, on this active layer 103, a cladding layer 104 consisting of a p-type GaAlAs layer is formed with a thickness of about 1.5 μm. Additionally, a light absorbing layer 105 consisting of a $Ga_{1-y}Al_yAs(0 \leqq y \leqq 1)$ layer is formed on said cladding layer 104.

On said light absorbing layer 105, an active layer 107 consisting of an n-type GaAs layer is selectively formed with a thicknes of about 0.2 μm via a semi-insulating $Ga_{1-z}Al_z(0 \leqq z \leqq 1)$ layer 106 having a thickness of about 5 μm.

A p-type region 108 which extends through the semi-insulating GaAlAs layer 106, the light absorbing layer 105 and part of the p-type cladding layer 104 is introduced in the portion of the region 107 LD where a semiconductor laser element LD is formed, and an electrode 109 is formed on said p-type region 108.

In addition, a Schottky contact electrode 110 and an ohmic contact electrode 111 are deposited on the active layer 107 DE-1 on which electrical circuit elements are arranged, thus forming a Schottky diode, while a Schottky gate electrode 112, a source electrode 113, and a

drain electrode 114 are deposited on the active layer 107 ED-2, thus forming a Schottky barrier-type field effect transistor.

Meanwhile, an electrode 115 is also deposited on the back side surface of the $n^+$-type GaAs substrate.

In such a structure, the light absorbing layer 105 may have a high resistance or insulating property.

In this optical semiconductor device, the semiconductor laser element LD is driven and controlled by electrical circuit elements ED.

The active layer 103 has the following composition: $Ga_{0.95}Al_{0.05}As$, when the light wavelength is 0.85 µm, while the light absorbing layer 105 has the following composition: $Ga_{0.98}Al_{0.02}As$, when the wavelength at the absorbing edge is 0.88 µm.

A part of the output light of the semiconductor laser element LD leaks and propagates towards the electrical circuit elements ED, but it is attenuated by the light absorbing layer 105 and does not reach the electrical circuit elements ED.

Even if the leaking light partly reaches the electrical circuit elements, it has a sufficiently low intensity to cause no malfunction of electrical circuit elements ED. The thickness d of the light absorbing layer 105 is selected, as explained above, so that it satisfies $\alpha d \geqq 1$, with an absorption coefficient α. Since the light is absorbed in accordance with $\exp(-\alpha d)$, when $\alpha d = 1$, for example, the incident light is reduced by l/e by absorption. Therefore, when $\alpha d \geqq 1$, a greater part of incident light is absorbed and it is attenuated to l/e or less. The thickness $d \geqq 0.5$ µm satisfies the relation $\alpha d \geqq 1$ when $\alpha = 2 \times 10^4 cm^{-1}$.

Also, the composition of the light absorbing layer 105 should be selected so that the concentration of aluminium (Al) be lower than or equal to that of the active layer 103 of the semiconductor laser element LD ($x \geqq y$). A crystal material having such a composition absorbs the light emitted from the active layer 103 in accordance with $\exp(-\alpha d)$. Therefore, the light does not reach the electrical circuit elements and no kind of malfunction occurs.

Fig. 8 shows an example of modification of the optical semiconductor device of Fig. 7, as a further optical semiconductor device. The portions corresponding to those shown on Fig. 7 are given the same reference numbers and symbols as those used on Fig. 7.

In the optical semiconductor device shown on Fig. 8, a semi-insulating GaAs substrate 121 is used as substrate.

For this reason, an $n^+$-type GaAs contact layer 122 is formed at least in the region corresponding to the area located below the semiconductor laser element LD on the semi-insulating GaAs substrate 121 and an electrode 123 is deposited on the $n^+$-type GaAs layer 122.

When the active layer 107, on which the electrical circuit elements ED are arranged, is formed by using InGaAsP layer or InGaAs crystal in order to realize improved high speed operation of the electrical circuit elements ED in the optical semiconductor device shown on Fig. 7, the light absorbing layer 105 is also formed of InGaAsP crystal. Thereby, leakage light from a semiconductor laser element LD is prevented to reach electrical circuit elements ED.

When an InP system semiconductor material is used in the optical semiconductor device shown in Fig. 7, the substrate 101 is composed of an $n^+$-type InP substrate; the n-type buffer layer/cladding layer 102, of an n-type InP layer; the active layer 103, of an InGaAsP layer; and the p-type cladding layer 104, of a p-type InP layer respectively. In addition, the semi-insulating layer 106 is formed of a semi-insulating InP or InGaAsP layer.

In this case, the compositions of active layer and light absorbing layer are adequately selected in accordance with the wavelength of the light emitted and of that at the absorbing edge.

Use of a semi-insulating layer as said InGaAsP system substrate also provides an effect similar to that of the embodiment shown in Fig. 8.

In the embodiments shown in Fig. 7 and Fig. 8, only one light absorbing layer 105 is interposed, but a similar effect can also be obtained with light absorbing means in the form of a plurality of layers provided that the sum of the products of absorbing coefficient with thickness for each layer is equal to or larger than 1.

Even when the semiconductor laser element and electrical circuit elements are arranged in parallel, unlike the vertical arrangement in above embodiment, isolation from light can also be obtained by interposing light absorbing layers between these elements. Namely, isolation from light can be realized by inserting a light absorbing layer after forming an electrical isolation between respective elements with a mesa type structure etc. It should be noted that the effect of the present invention is not deteriorated at all even when the above inserted layer is formed not only of a crystal having a forbidden band narrower than that of the light emitting or light receiving region of the optical semiconductor element but also of a resin, plastic or metal etc.

**Claims**

1. An optical semiconductor device comprising a semiconductor substrate (51, 71, 101) having top and bottom surfaces, a light emitting element (55a, 55b ... LD) formed on the semiconductor substrate, at least another semiconductor element (55c, PT, ED) formed on the semiconductor substrate adjacent to said light emitting element, and an electrode formed on said bottom surface (63, 85, 115), characterized in that a light absorbing layer (53, 57, 72, 105) is formed directly or indirectly on the semiconductor substrate (51, 71, 101) between said other semiconductor element and said electrode, so as to prevent leakage light from said light emitting element, even when it is reflected by said electrode, to reach said other semiconductor element.

2. An optical semiconductor device in accordance with claim 1, characterized in that said light

absorbing layer has a thickness and an absorption coefficient such that the product of the thickness d (cm) and absorption coefficient $\alpha$ ($cm^{-1}$) is greater than or equal to 1.

3. An optical semiconductor device in accordance with claim 1 or 2, characterized in that said other semiconductor element is a light emitting element (55b, 55a, . . .).

4. An optical semiconductor device in accordance with claim 3, characterized by comprising:

a semiconductor substrate (51) having top and bottom surfaces;

an electrode (63) formed on the bottom surface of said semiconductor substrate;

a buffer layer (52) on the top surface of said semiconductor substrate;

a first light absorbing layer (53) formed on said buffer layer;

a first clad layer (54) formed in selected portions of said first light absorbing layer (53) so that remaining portions (53a, 53b, . . .) of said first light absorbing layer exist between said selected portions;

active layers (55a, 55b, . . .) formed in said first clad layer;

a second clad layer (56) formed on said active layer (55a, 55b, . . .), said first clad layer (54) and said remaining portions (53a, 53b, . . .) of said first light absorbing layer;

a second light absorbing layer (57) formed on said second clad layer;

a contact layer (48) formed on said second light absorbing layer;

high resistance regions (61a, 61b, . . .) formed in portions of said contact layer (58), said second light absorbing layer (57) and said second clad layer (56), and disposed above said remaining portions (53a, 53b, . . .) of said first light absorbing layer;

current path regions (59a, 59b, . . .) formed in portions of said contact layer (58), said second light absorbing layer (57) and said second clad layer (56), and disposed above said active layers (55a, 55b, . . .);

insulating layer (60) formed on said high resistance regions (61a, 61b, . . .); and

electrodes (62) formed on said current path regions and covering portions of said insulating layer.

5. An optical semiconductor device in accordance with claim 1 or 2, characterized in that said other semiconductor element is a light detecting element (PT).

6. An optical semiconductor device in accordance with claim 5, characterized in that the light absorbing layer (72) is formed on the semiconductor substrate (71) just below said light emitting element (LD) or said light detecting element (PT), between said light emitting and said light detecting elements, said electrode (85) reflecting light from said light emitting element (LD).

7. An optical semiconductor device in accordance with claim 1 or 2, characterized in that said other semiconductor element comprises at least one electrical circuit element (ED) such a transistor.

8. An optical semiconductor device in accordance with claim 7, characterized by comprising:

a semiconductor substrate (101) having top and bottom surfaces;

an electrode (115) formed on the bottom surface of said semiconductor substrate;

a buffer layer (102) formed on the top surface of said semiconductor substrate;

an active layer (103) formed on said buffer layer;

a clad layer (104) formed on said active layer;

a light absorbing layer (105) formed on said clad layer;

a semi-insulating layer (106) formed on said light absorbing layer;

active regions (107) formed on said semi-insulating layer;

a p-type region (108) formed in a portion of said clad layer (104), light absorbing layer (105), semi-insulating layer (106) and one of said active regions (107), for forming a laser element (LD); and

electrical circuit elements (ED, 110—114) formed in said remaining active regions.

**Patentansprüche**

1. Optische Halbleitervorrichtung mit einem Halbleitersubstrat (51, 71, 101) mit oberen und unteren Oberflächen, einem lichtemittierenden Element (55a, 55b . . . LD), das auf dem Halbleitersubstrat gebildet ist, wenigstens einem anderen Halbleiterelement (55c, PT, ED), das auf dem Halbleitersubstrat nahe bei dem genannten lichtemitterenden Element gebildet, ist, und einer Elektrode, die auf der unteren Oberfläche (63, 85, 115) gebildet ist, dadurch gekennzeichnet, daß eine lichtabsorbierende Schicht (53, 57, 72, 105) direkt oder indirekt auf dem Halbleitersubstrat (51, 71, 101) zwischen dem gennanten anderen Halbleiterelement und der genannten Elektrode gebildet ist, um so ein Auslecken von Licht von dem lichtemittierenden Element zu verhindern, selbst wenn es von der genannten Elektrode reflektiert wird, um das genannte andere Halbleiterelement zu erreichen.

2. Optische Halbleitervorrichtung nach Anspruch 1, dadurch gekennzeichnet, daß die lichtabsorbierende Schicht eine solche Dicke und einen solchen Absorptionskoeffizienten hat, daß das Produkt der Dicke d (cm) und des Absorptionskoeffizienten $\alpha$($cm^{-1}$) größer oder gleich 1 ist.

3. Optische Halbleitervorrichtung nach Anspruch 1 oder 2, dadurch gekennzeichnet, daß das genannte andere Halbleiterelement ein lichtemittierendes Element (55b, 55a, . . .) ist.

4. Optische Halbleitervorrichtung nach Anspruch 3, dadurch gekennzeichnet, daß sie umfaßt:

ein Halbleitersubstrat (51) mit oberen und unteren Oberflächen;

eine Elektrode (63), die auf der unteren Oberfläche des genannten Halbleitersubstrats gebildet ist;

eine Pufferschicht (52) auf der oberen Oberfläche des genannten Halbleitersubstrats;

eine erste lichtabsorbierende Schicht (53), die auf der genannten Pufferschicht gebildet ist;

eine erste Auskleidungsschicht (54), die in ausgewählten Abschnitten der genannten ersten lichtabsorbierenden Schicht (53) gebildet ist, so daß verbleibende Abschnitte (53a, 53b, ...) der genannten ersten lichtabsorbierenden Schicht zwischen den genannten ausgewählten Abschnitten existieren;

aktive Schichten (55a, 55b, ...), die in der genannten ersten Auskleidungsschicht gebildet sind;

eine zweite Auskleidungsschicht (56), die auf den genannten aktiven Schichten (55a, 55b, ...), der genannten ersten Auskleidungsschicht (54) und den genannten verbleibenden Abschnitten (53a, 53b, ...) der genannten ersten lichtabsorbierenden Schicht gebildet ist;

eine zweite lichtabsorbierende Schicht (57), die auf der genannten zweiten Auskleidungsschicht gebildet ist;

eine Kontaktschicht (48), die auf der genannten zweiten lichtabsorbierenden Schicht gebildet ist;

Bereiche hohen Widerstandes (61a, 61b, ...), die in Abschnitten der genannten Kontaktschicht (58), der genannten zweiten lichtabsorbierenden Schicht (57) und der genannten zweiten Auskleidungsschicht (56) gebildet und oberhalb der genannten verbleibenden Abschnitte (53a, 53b, ...) der genannten ersten lichtabsorbierenden Schicht angeordnet sind;

Stromwegbereiche (59a, 59b, ...), die in Abschnitten der genannten Kontaktschicht (58), der genannten zweiten lichtabsorbierenden Schicht (57) und der genannten zweiten Auskleidungsschicht (56) gebildet und oberhalb der genannten aktiven Schichten (55a, 55b, ...) angeordnet sind;

eine isolierende Schicht (60), die auf den genannten Bereichen (61a, 61b, ...) hohen Widerstands gebildet ist; und

Elektroden (62), die auf den genannten Stromwegbereichen gebildet sind und Abschnitte der genannten Isolierschicht bedecken.

5. Optische Halbleitervorrichtung nach Anspruch 1 oder 2, dadurch gekennzeichnet, daß das genannte andere Halbleiterelement ein lichtdetektierendes Element (PT) ist.

6. Optische Halbleitervorrichtung nach Anspruch 5, dadurch gekennzeichnet, daß die lichtabsorbierende Schicht (72) auf dem Halbleitersubstrat (71) direkt unterhalb des genannten lichtemittierenden Elements (LD) oder des lichtdetektierenden Elements (PT) gebildet ist, zwischen den genannten lichtemittierenden und den genannten lichtdetektierenden Elementen, wobei die genannte Elektrode (85) Licht von dem genannten lichtemittierenden Element (LD) reflektiert.

7. Optische Halbleitervorrichtung nach Anspruch 1 oder 2, dadurch gekennzeichnet, daß das genannte andere Halbleiterelement wenigstens ein elektisches Schaltungselement (ED) wie einen Transistor umfaßt.

8. Optische Halbleitervorrichtung nach Anspruch 7, dadurch gekennzeichnet, daß sie umfäßt;

ein Halbleitersubstrat (101), das obere und untere Oberflächen hat;

eine Elektrode (115), die auf der unteren Oberfläche des genannten Halbleitersubstrats gebildet ist;

eine Pufferschicht (102), die auf der oberen Oberfläche des genannten Halbleitersubstrats gebildet ist;

eine aktive Schicht (103), die auf der genannten Pufferschicht gebildet ist;

eine Auskleidungsschicht (104), die auf der genannten aktiven Schicht gebildet ist;

eine lichtabsorbierende Schicht (105), die auf der genannten Auskleidungsschicht gebildet ist;

eine halbisolierende Schicht (106), die auf der genannten lichtabsorbierenden Schicht gebildet ist;

aktive Bereiche (107), die auf der genannten halbisolierenden Schicht gebildet sind;

einen p-Typ-Bereich (108), der in einem Abschnitt der genannten Auskleidungsschicht (104), der lichtabsorbierenden Schicht (105), der halbisolierenden Schicht (106) und einem der genannten Bereiche (107) gebildet ist, um ein Laserelement (LD) zu bilden; und

elektrische Schaltungselemente (ED, 110—114), die in den genannten verbleibenden aktiven Bereichen gebildet sind.

**Revendications**

1. Dispositif semiconducteur optique comprenant un substrat semiconducteur (51, 71, 101) possédant des surfaces supérieure et inférieure, un élément d'émission de lumière (55a, 55b, ..., LD) formé sur le substrat semiconducteur, au moins un autre élément semiconducteur (55c, PT, ED) formé sur le substrat semiconducteur au voisinage dudit élément d'émission de lumière, et une électrode formée sur ladite surface inférieure (63, 85, 115), caractérisé en ce qu'une couche d'absorption de lumière (53, 57, 72, 105) est formée directement ou indirectement sur le substrat semiconducteur (51, 71, 101) entre ledit autre élément semiconducteur et ladite électrode, de manière à empêcher qu'une lumière de fuite venant dudit élément d'émission de lumière, même lorsqu'elle est réfléchie par ladite électrode, n'atteigne ledit autre élément semiconducteur.

2. Dispositif semiconducteur optique selon la revendication 1, caractérisé en ce que ladite couche d'absorption de lumière possède un épaisseur et un coefficient d'absorption tel que le produit de l'épassieur $d$ (cm); et du coefficient d'absorption $\alpha(cm^{-1})$ est supérieur ou égal à 1.

3. Dispositif semiconducteur optique selon la revendication 1 ou 2, caractérisé en ce que ledit autre élément semiconducteur est un élément

semiconducteur est un élément d'émission de lumière (55b, 55a, . . .).

4. Dispositif semiconducteur optique selon la revendication 3, caractérisé en ce qu'il comprend:

un substrat semiconducteur (51) possédant des faces supérieure et inférieure;

un électrode (63) formée sur la face inférieure dudit substrat semiconducteur;

une couche tampon (52) disposée sur la face supérieur dudit substrat semiconducteur;

un première couche d'absorption de lumière (53) formée sur ladite couche tampon;

un première couche de revêtement (54) formée dans des parties sélectionnées de ladite premièré couche d'absorption de lumière (53) de façon que des parties restantes (53a, 53b, . . .) de ladite première couche d'absorption de lumière existent entre lesdites parties sélectionnées;

des couches actives (55a, 55b, . . .) formées dans ladite première couche de revêtement;

une deuxième couche de revêtement (56) formée sur lesdites couches actives (55a, 55b, . . .), ladite première couche de revêtement (54) et lesdites parties restantes (53a, 53b, . . .) de ladite première couche d'absorption de lumière;

une deuxième couche d'absorption de lumière (57) formée sur ladite deuxième couche de revêtement;

une couche de contact (48) formée sur ladite deuxième couche d'absorption de lumière;

des régions à résistance élevée (61a, 61b, . . .) formées dans des parties de ladite couche de contact (58), de ladite deuxième couche d'absorption de lumière (57) et de ladite deuxième couche de revêtement (56), et disposées au-dessus desdites parties restantes (53a, 53b, . . .) de ladite première couche d'absorption de lumière;

des régions de trajet de courant (59a, 59b, . . .) formées dans des parties de ladite couche de contact (58), de ladite deuxième couche d'absorption de lumière (57) et de ladite deuxième couche de revêtement (56), et disposées au-dessus desdites couches actives (55a, 55b, . . .);

une couche isolante (60) formée sur lesdites régions à résistance élevée (61a, 61b, . . .); et

des électodes (62) formées sur lesdites régions de trajet de courant et couvrant des parties de ladite couche isolante.

5. Dispositif semiconducteur optique selon la revendication 1 ou 2, caractérisé en ce que ledit autre élément semiconducteur est un élément de détection de lumière (PT).

6. Dispositif semiconducteur optique selon la revendication 5, caractérisé en ce que la couche d'absorption de lumière (72) est formée sur le substrat semiconducteur (71) juste au-dessous dudit élément d'émission de lumière (LD) ou dudit element de détection de lumière (PT), entre lesdits éléments d'emission de lumière et de détection de lumière, ladite électrode (85) réfléchissant la lumière qui vient dudit élement d'émission de lumière (LD).

7. Dispositif semiconducteur optique selon la revendication 1 ou 2, caractérisé en ce que ledit autre élément semiconducteur comprend au moins un élément de circuit électrique (ED), tel qu'un transistor.

8. Dispositif semiconducteur optique selon la revendication 7, caractérisé en ce q'il comprend:

un substrat semiconducteur (101) possédant des faces supérieure et inférieure;

une électrode (115) formée sur la face inférieure dudit substrat semiconducteur;

une couche tampon (102) formée sur la face supérieur dudit substrat semiconducteur;

une couche active (103) formée sur ladite couche tampon;

une couche de revêtement (104) formée sur ladite couche active;

une couche d'absorption de lumière (105) formée sur ladite couche de revêtement;

une couche semi-isolante (106) formée sur ladite couche d'absorption de lumière;

des couches actives (107) formées sur ladite couche semi-isolante;

un région de type p (108) formée dans une partie de ladite couche de revêtement (104), de la couche d'absorption de lumière (105), de la couche semi-isolante (106) et d'une desdites régions actives (107), afin de former un élément laser (LD); et

des éléments de circuit électriques (ED, 110—114) formés dans lesdits régions actives restantes.

Fig. 1

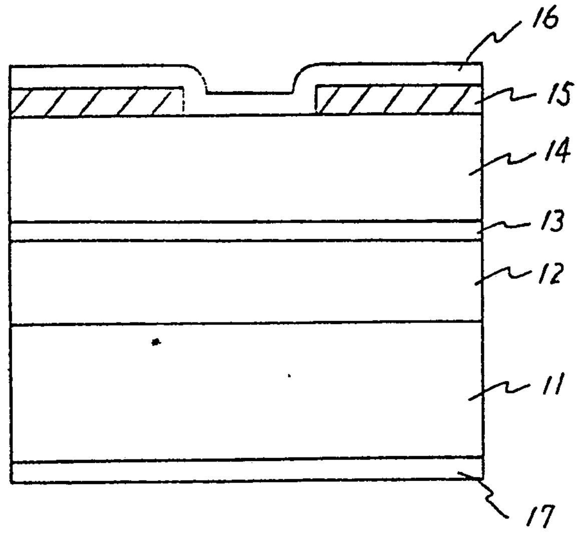


Fig. 2

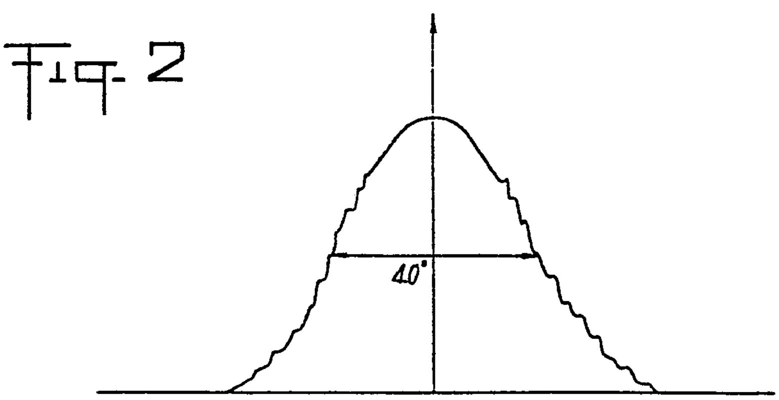

Fig. 3

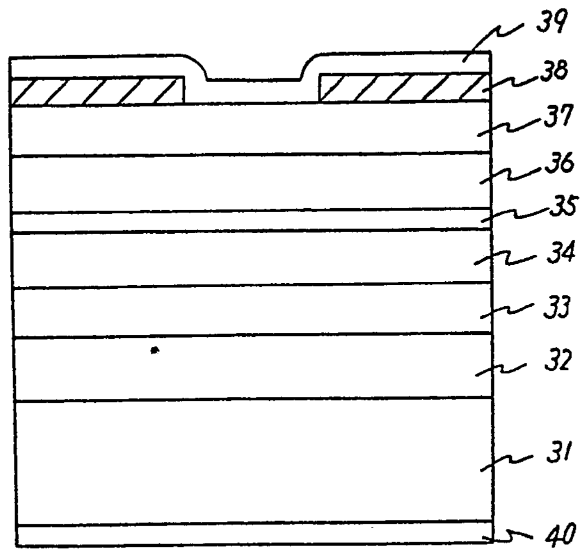


Fig. 4

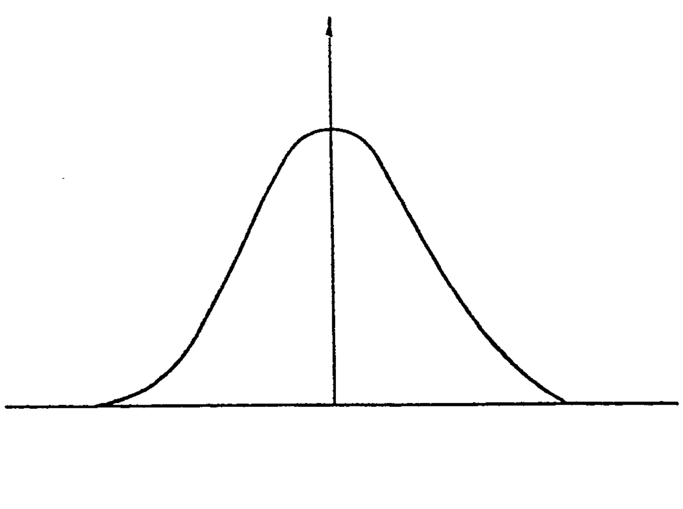

Fig. 5

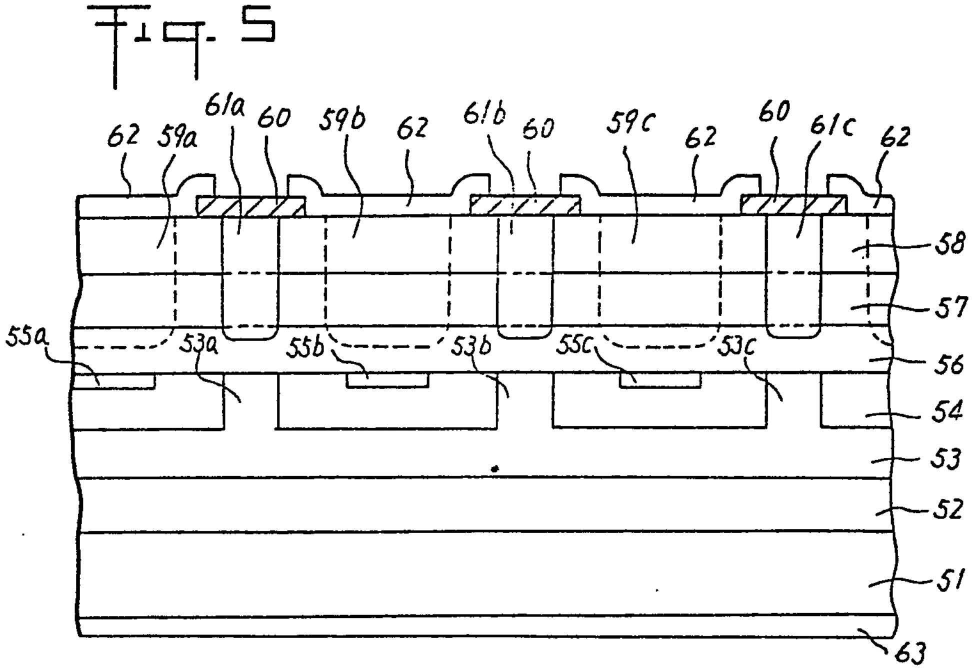
62
59a
61a
60
59b
62
61b
60
59c
62
60
61c
62
58
57
55a
53a
55b
53b
55c
53c
56
54
53
52
51
63

Fig. 6

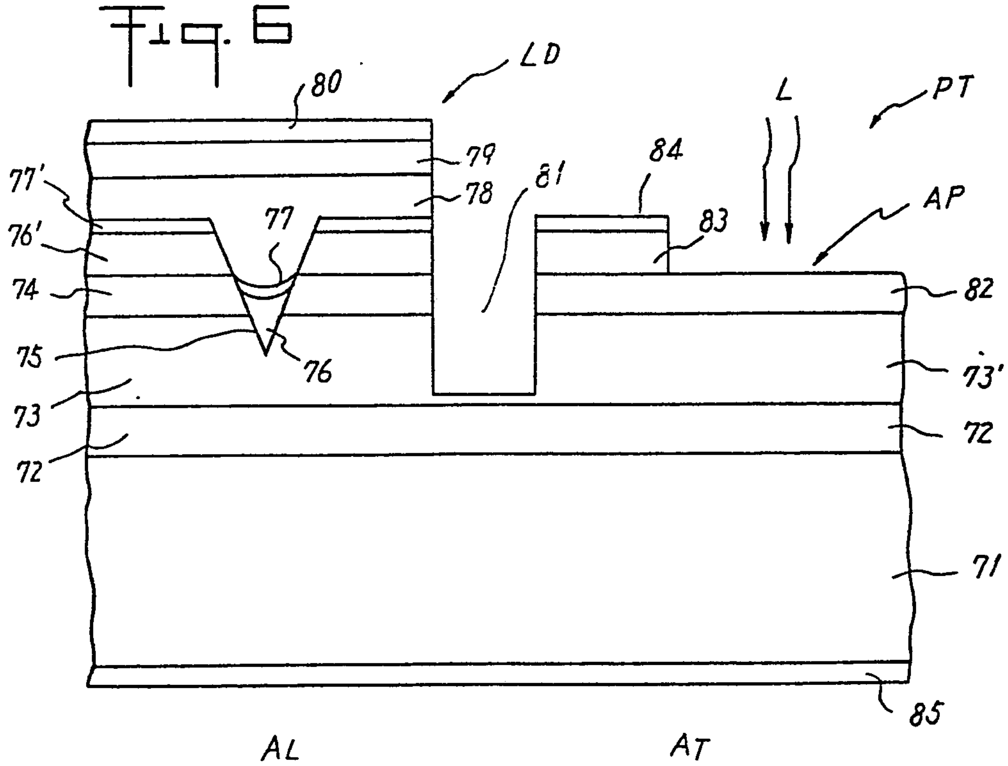
80
LD
L
PT
79
77'
78
81
84
77
83
AP
76'
74
82
75
76
73
73'
72
72
71
85
AL
AT

Fig. 7

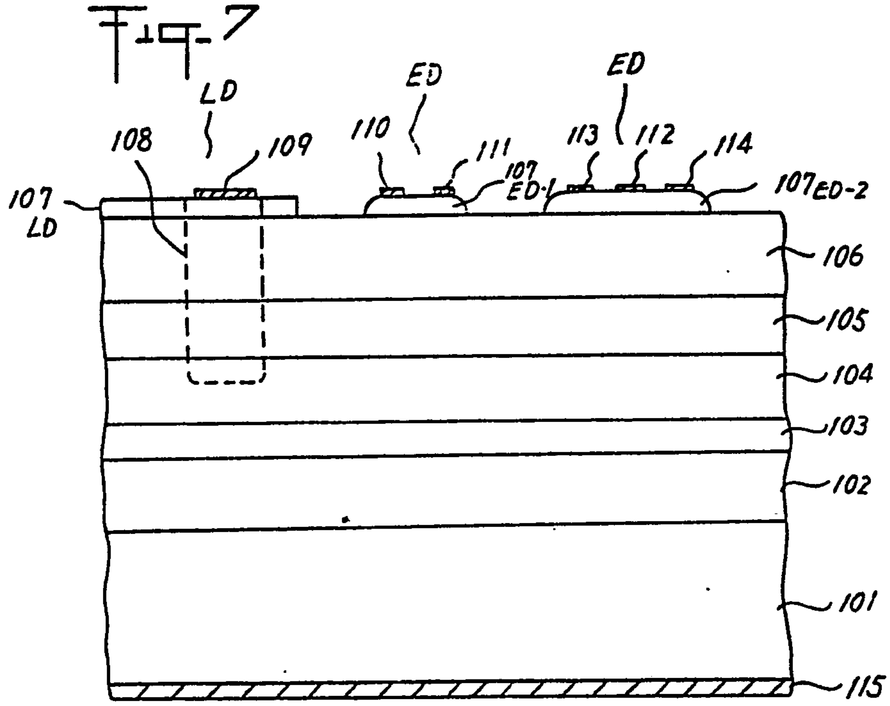
LD
ED
ED
108
109
110
111
113
112
114
107 ED-1
107 ED-2
107 LD
106
105
104
103
102
101
115

Fig. 8

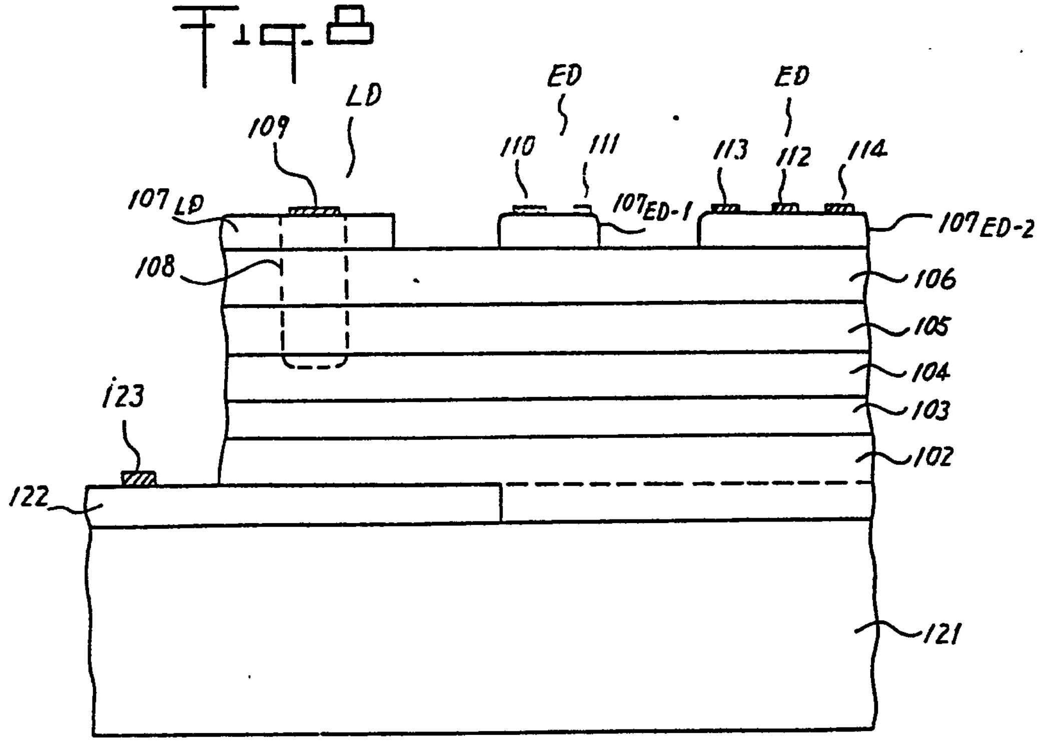
ED
ED
LD
109
110
111
113
112
114
107 LD
107 ED-1
107 ED-2
108
106
105
104
103
102
123
122
121